Europäisches Patentamt

European Patent Office

Office européen des brevets

(11) Veröffentlichungsnummer: **0 357 961**
**A2**

## (12) EUROPÄISCHE PATENTANMELDUNG

(21) Anmeldenummer: **89114355.4**

(22) Anmeldetag: **03.08.89**

(51) Int. Cl.5: **B23Q 17/24**

(30) Priorität: **10.08.88 DE 3827155**

(43) Veröffentlichungstag der Anmeldung:
**14.03.90 Patentblatt 90/11**

(84) Benannte Vertragsstaaten:
**AT BE CH DE ES FR GB GR IT LI LU NL SE**

(71) Anmelder: **ROOSEN, Reiner**
**Schachenwaldstrasse 30**
**D-6450 Hanau 7(DE)**

(72) Erfinder: **ROOSEN, Reiner**
**Schachenwaldstrasse 30**
**D-6450 Hanau 7(DE)**

(74) Vertreter: **Stoffregen, Hans-Herbert, Dr.**
**Dipl.-Phys. et al**
**Patentanwälte Strasse & Stoffregen**
**Salzstrasse 11a Postfach 2144**
**D-6450 Hanau/Main 1(DE)**

(54) **Verfahren und Vorrichtung zum Bohren von Löchern in eine Druckplatte.**

(57) Es wird ein Verfahren und eine Vorrichtung zum Einbringen wie Bohren von Löchern (17, 19) in einer Druckplatte (11) vorgeschlagen. Jedem Werkzeug (34) ist dabei ein optisches Abbildungssystem (38) zugeordnet, um eine Ausrichtung des Werkzeuges auf eine Markierung (13, 15) vornehmen zu können. Die von den Abbildungssystemen gewonnenen Bilder werden deckungsgleich auf einer einzigen Abbildungsfläche (44) dargestellt,

FIG.1

EP 0 357 961 A2

## Verfahren und Vorrichtung zum Bohren von Löchern in eine Druckplatte

Die Erfindung bezieht sich auf ein Verfahren zum Bohren von Löchern in eine Druckplatte insbesondere aus photopolymerem Material oder Gummi, wobei Bohrwerkzeuge und optische Abbildungssysteme auf auf der Druckplatte vorhandene Markierungen ausgerichtet werden, sowie auf eine Vorrichtung zur Durchführung des Verfahrens.

Um Druckplatten insbesondere aus photopolymerem Material auf einen Druckzylinder anzuordnen, ist es erforderlich, das Bohrungen in den Positionen angeordnet werden, in denen Stifte einer der Druckplatte zugeordneten Anordnung verlaufen. Eine solche Anordnung kann eine Schiene sein, wie sie in der US-PS 4,604,811 beschrieben ist. Hierdurch soll sichergestellt werden, daß die Druckplatte in der richtigen Position auf dem Druckzylinder angeordnet wird, was insbesondere bei einem Mehrfarbendruck zur Vermeidung von Fehlern wie z.B. Farbunschärfen zwingend erforderlich ist.

Nach dem Stand der Technik erfolgt das Bohren von Hand, wobei die Bohrer individuell auf Markierungen ausgerichtet werden. Hierdurch bedingt ist es immer wieder festzustellen, daß die Bohrlöcher geringfügig von den vorgegebenen Markierungen abweichen, so daß die Qualität des Druckes häufig nicht den gewünschten Anforderungen entspricht.

Aufgabe der vorliegenden Erfindung ist es, ein Verfahren und eine Vorrichtung der eingangs genannten Art so auszubilden, daß sichergestellt ist, daß die Bohrlöcher in eindeutiger Zuordnung zu auf der Druckplatte vorhandenen Markierungen vorliegen, so daß die gewünschte genaue Positionierung auf dem Druckzylinder gewährleistet ist.

Die Aufgabe wird im wesentlichen durch ein Verfahren gelöst, das sich dadurch auszeichnet, daß jeder Bohrer einem optischen Abbildungssystem zugeordnet wird, daß die von den Abbildungssystemen erfaßten Markierungen auf eine einzige Beobachtungsfläche abgebildet werden und daß die Löcher dann eingebracht werden, wenn die Markierungen deckungsgleich auf der Beobachtungsfläche abgebildet sind. Dabei sind die Markierungen vorzugsweise Kreuze, deren Achsen deckungsgleich mit den Achsen eines auf der Beobachtungsfläche vorhandenen Kreuzes zu bringen sind. Letzteres kann als Doppelkreuz ausgebildet werden, innerhalb dessen die Kreuze der Markierungen zu liegen kommen.

Mit anderen Worten wird durch die erfindungsgemäße Lehre die Möglichkeit geschaffen, auf einer einzigen Beobachtungsfläche wie z.B. einen Bildschirm oder Monitor feststellen zu können, ob sämtliche Bohrer zu den ihnen zugeordneten Markierungen richtig ausgerichtet sind, um sodann die Bohrungen synchron vorzunehmen.

Die erfindungsgemäße Lehre ermöglicht demzufolge ein automatisches Bohren, wobei die Gefahr von Fehlbohrungen grundsätzlich nicht mehr auftreten kann, da bei einem manuellen Betätigen der Bohrer das Bedienungspersonal nur noch eine Beobachtungsfläche wie Bildschirm beobachten muß und leicht erkennen kann, ob die Bohrer auf die Markierungen richtig ausgerichtet sind oder nicht. Selbstverständlich kann auch ein vollautomatischer Bohrvorgang erfolgen, in dem die von den Abbildungssystemen gewonnenen Informationen digitalisiert und einer Steuer- und Recheneinheit zugeführt werden, um die ermittelten Signale mit abgespeicherten Signale zu vergleichen und bei Übereinstimmungen die Bohrungen vornehmen zu lassen.

Zwar gibt es nach dem Stand der Technik bereits Verfahren zum Einbringen von Löchern in Filmen, bei denen ebenfalls optische Systeme zur Überwachung benutzt werden. So wird in der DE-OS 30 31 650 ein Verfahren und eine Vorrichtung zum Stanzen von Filmen beschrieben, bei dem jedoch jeder Bereich, in dem eine Stanzung vorgenommen werden soll, durch ein gesondertes optisches System überwacht und auf getrennten Bildschirmen abgebildet wird. Eine solche Technik ist mit der erfindungsgemäßen nicht zu vergleichen, da sukzessiv das Beobachten einzelner Stanzwerkzeuge erfolgt, so daß hierdurch bedingt erneut die Gefahr von Fehlstanzungen auftritt. Die optischen Systeme nach dem Stand der Technik stellen folglich in etwa nur eine Vergrößerung der Markierung und damit eine bessere Erfassung dieser dar, ohne daß das erfindungsgemäße gleichzeitige Ausrichten sämtlicher Bohrer auf die Ihnen zugeordneten Markierungen und sodann das gleichzeitige, also synchrone Bohren erfolgt. Ferner kann stets nur im fest vorgegebenen Abstand zu einem Anschlag, an dem ein Rand der Platte anliegen muß, gebohrt werden, so daß bei fehlerhafter Ausrichtung des Films zu dem Anschlag die Löcher nicht in der gewünschten Position vorliegen. Erfindungsgemäß dienen nur die Markierungen als Fixpunkte für die Löcher, die folglich unabhängig von der Ausgangslage der Druckplatte, und ohne daß diese an einem Anschlag liegen muß, positionsgenau angebracht werden.

Die Zuordnung von Bohrer und optischem System und die Abbildung der Markierung auf die einzige Beobachtungsfläche erfolgt vorzugsweise dabei so, daß der Bohrer in bezug auf die Markierung dann richtig ausgerichtet ist, wenn die Markierung in dem Zentrum eines Fadenkreuzes abgebildet ist, daß sich auf dem Bildschirm befindet. Hierdurch wird eine weitere Vereinfachung vorgenommen.

Insbesondere zeichnet sich die Erfindung durch die Verfahrensschritte aus:

a) Auflegen einer Photopolymerplatte auf eine ebene Fläche wie Tisch,

b) Verschieben des optischen Systems und/oder der Photopolymerplatte derart, daß die Markierungen deckungsgleich auf einer optischen Beobachtungsfläche und vorzugsweise auf einer Markierung auf dieser abgebildet werden,

c) Fixieren der Photopolymerplatte auf der Fläche durch Unterdruck und/oder Niederhalter,

d) gegebenenfalls Verschieben der Fläche zum erneuten Ausrichten der Abbildungen der Markierungen auf der optischen Beobachtungsfläche und

e) Bohren der Photopolymerplatte.

Eine Vorrichtung zum Bohren von Löchern in eine Druckplatte insbesondere aus photopolymerem Material oder Gummi, wobei die Bohrer nach Ausrichten auf zu bohrenden Löchern zugeordnete Markierungen betätigbar sind, zeichnet sich nach einem selbständigen Lösungsvorschlag dadurch aus, daß jedem Bohrer ein auf die Markierung ausrichtbares optisches Abbildungssystem zugeordnet ist und daß zur Abbildung der von den Abbildungssystemen erfaßten Bilder eine einzige Beobachtungsfläche vorgesehen ist. Dabei ist vorzugsweise jeder Bohrer und das zugeordnete Abbildungssystem an einem Schlitten befestigt, der relativ zu der Druckplatte bewegbar ist. Die Bewegung kann dabei dreidimensional oder aber auch nur zweidimensional sein.

Letzteres ist dann der Fall, wenn die Werkzeuge nur entlang einer Linie bewegbar und absenkbar bzw. anhebbar sind. Bei dieser Art wird die Druckplatte durch Verschieben auf einer Unterlage auf die Werkzeuge ausgerichtet. Eine dreidimensionale Bewegung erfolgt, wenn bei fixierter Druckplatte die Werkzeuge auf die Markierungen ausgerichtet werden.

Insbesondere können sämtliche Schlitten entlang der selben Führungs- bzw. Halteelemente wie Wellen verschiebbar ausgebildet sein, die ihrerseits in bezug auf die auf einer Bearbeitungsfläche wie Tisch aufliegende Druckplatte parallel und senkrecht relativ zu dieser bewegbar sind. Demzufolge wird mit konstruktiv einfachen, jedoch stabilen Elementen wie Schlitten und Schienen bzw. Wellen eine Vorrichtung zur Verfügung gestellt, die von der mechanischen Seite robust ausgebildet und damit störunanfällig ist. Die Druckplatten können auf der Bearbeitungsfläche durch Ansaugen lagefixiert werden, um ein Verrutschen insbesondere beim Bohren auszuschließen. Zusätzlich oder alternativ kann die Platte während des Bohrens von einem Niederhalter befestigt werden, der in bezug auf das Werkzeug pendelnd gelagert ist. Hierdurch wird ermöglicht, daß die Unterlage nach Fixieren der Platte zu dem optischen System und damit den Werkzeugen bewegt werden kann.

Die Unterlageplatte kann dabei gleitend über z.B. Teflon Gleitelemente gelagert und bei gewünschter Ausrichtung auf die optischen Systeme mittels Magnet festgelegt werden.

Das optische System, das vorzugsweise als Videoabbildungssystem oder Endoskop ausgebildet ist, ist dabei nach einer weiteren hervorzuhebenden Ausgestaltung der Erfindung mit dem Bohrer an einer Halterung befestigt, die zum einen vom Schlitten ausgeht. Vorteilhafterweise kann die Halterung zusätzlich um die Bohrer-oder Stanzlängsachse drehbar sein. Ferner kann die Halterung relativ zu dem Schlitten, und zwar vorzugsweise senkrecht zu den Führungs- bzw. Halteelementen verschoben werden. Hierdurch ergibt sich die Möglichkeit, daß mit ein und derselben Vorrichtung verschiedenste Druckplatten mit Löchern versehen sein können, bei denen nicht notwendigerweise der Rand der Druckplatte nicht genau auf die Bezugslinie wie Anschlag ausgerichtet ist.

Das Einstellen des Schlittens und der Halterung, also die Winkeleinstellung von Bohrer und optischem System in bezug auf eine durch die Drehachse der Halterung verlaufenden Achse kann vorzugsweise mittels eines Schrittmotors erfolgen, deren Stellung elektrisch abgetastet und bei der Verarbeitung der von dem Abbildungssystem erfaßten Signale mitberücksichtigt werden kann.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung eines in der Zeichnung dargestellten bevorzugten Ausführungsbeispiels.

Es zeigen:

Fig. 1 eine Vorrichtung zum Bohren von Löchern in eine Druckplatte,

Fig. 2 eine Detaildarstellung eines Ausschnittes der Vorrichtung nach Fig. 1,

Fig. 3 eine Draufsicht der Darstellung nach Fig. 2,

Fig. 4 eine Detaildarstellung eines Schlittens und

Fig. 5 eine Prinzipdarstellung einer bevorzugten Vorrichtung zum Bohren von Löchern in einer Druckplatte.

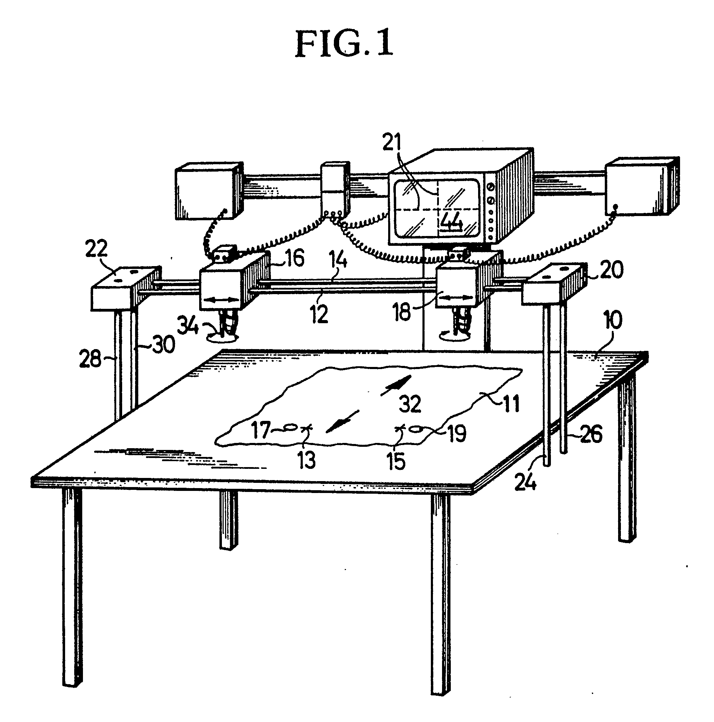

In Fig. 1 ist eine Vorrichtung zum Bohren von Löchern (17) und (19) in einer Druckplatte (11) dargestellt, die auf einer Bearbeitungsfläche wie Bearbeitungstisch (10) liegt. Im Tisch können von der Druckplatte (11) abgedeckte Aussparungen vorgesehen sein, innerhalb derer ein Unterdruck erzeugbar ist. Hierdurch wird die Druckplatte festgesaugt, so daß beim Bohren ein Verrutschen ausgeschlossen ist. Selbstverständlich ist kein Unterdruck vorhanden, wenn die Druckplatte (11) zur Ausrichtung auf Bohrwerkzeuge zu verschieben ist.

Entlang von Führungs- bzw. Halteschienen (12) und (14) sind Schlitten (16) und (18) verschiebbar. Sind im Ausführungs beispiel nur zwei Schlitten (16), (18) vorgesehen, so können selbstverständlich auch mehr Schlitten vorhanden sein. Die Schienen (12), (14) gehen von Halterungen (20), (22) aus, die entlang weiterer Führungs- bzw. Gleitstangen (24), (26) und (28), (30) verschiebbar sind. Ferner kann die die Führungsstangen (12), (14), (24), (26), (28), (30) umfassende Einheit parallel zu der Fläche (10) in Richtung der Pfeile (32) oder die Fläche (10) zu den erwähnten Elementen in Pfeilrichtung verschoben werden. Hierdurch ergibt sich eine dreidimensionale Bewegung der Schlitten (16) und (18) zu der Fläche (10) und damit zu der auf dieser ausgebreiteten Druckplatte.

Die Bewegung des Schlittens (16) und (18) sowie der Halterungen bzw. Aufnahmen (20) und (22) kann über nicht dargestellte Antriebe wie z.B. Schrittmotoren oder aber auch von Hand erfolgen.

Jeder Schlitten (16) und (18) umfaßt einen Bohrerantrieb mit vorzugsweise einem Hohlbohrer oder einem Stanzwerkzeug. Der vorzugsweise unmittelbar einen Antrieb umfassende Bohrer ist dabei von einer Halterung (40) aufgenommen, die außerdem ein optisches System in Form vorzugsweise eines Endoskops (38) trägt. Das optische System (38) ist drehbar in der Halterung (40) gelagert, und zwar um eine Achse (36), die mit der Achse des Hohlbohrers oder Stanzwerkzeugs zusammenfällt. Ferner kann die Halterung (40) relativ zu dem Schlitten (16) verschiebbar sein, wie der Pfeil (39) andeuten soll. Durch die Drehbarkeit und Verschiebbarkeit der Halterung (40) und damit des Bohrers (34) ist gewährleistet, daß dieser die gewünschte Position zu der zugeordneten Markierung einnehmen kann. Dabei erfolgt die Drehung des optischen Systems (38) um die Bohrerlängsachse, um so unter dem richtigen Winkel die Markierungen (13) und (15) zu erfassen.

Das optische System (38) wird nun durch Verschieben des Schlittens (16) entlang der Schienen (12) und (14) bzw. durch Verschieben der Aufnahmen (20) und (22) entlang der Schienen (24), (26), (28) und (30) parallel zu der Fläche (10) so auf einer auf der Druckplatte (11) vorhandenen Markierung (13) bzw. (15) ausgerichtet, daß der Hohlbohrer oder ähnliches zu dieser eine gewünschte Position einnimmt, in der das Loch (17) bzw. (19) gebohrt werden soll, das bei Aufbringen der Druckplatte (11) auf einen Druckzylinder von einem z.B. von einer Halteschiene ausgehenden Stift durchsetzt werden soll. Die Markierungen (13) und (15) liegen auf einer Geraden, die parallel zu der Achse eines Druckzylinders verläuft, auf den die Druckplatte (14) angeordnet werden soll.

Erfindungsgemäß werden die von dem optischen System (38) empfangenen Signale auf einer einzigen Beobachtungsfläche wie z.B. Monitor (44) über eine Mischvorrichtung nach vorzugsweise vorheriger Digitalisierung und/oder Bewertung abgebildet. Dabei ist erfindungsgemäß vorgesehen, daß die von sämtlichen optischen Systemen gewonnenen Signale auf dem Monitor (44) abgebildet werden, wobei dann der Bohrvorgang erfolgt, wenn die optischen Systeme die Markierungen (13) und (15) auf dem Bildschirm (44) deckungsgleich und auf ein Fadenkreuz (21) ausgerichtet abbilden, das auch als Hohlkreuz ausgebildet sein kann, innerhalb dessen die Markierungen auszubilden sind. Sobald diese bildliche Darstellung wahrnehmbar ist, ist sichergestellt, daß die Bohr- oder Stanzwerkzeuge die richtige Position in bezug auf die zugeordneten Markierungen (13) und (15) einnehmen, so daß durch Absenken der Halterung (20) und (22) entlang der Schienen (24), (26), (28) und (30) der Bohr-oder Stanzvorgang durchgeführt wird.

Bevorzugterweise umfaßt die Vorrichtung zwei Schlitten mit optischen Systemen und Werkzeugen zum Vornehmen der Löcher. Sofern mehr als zwei Löcher auf einer Druckplatte gebohrt werden sollen, müssen diese nach und nach von den Schlitten angefahren werden. Selbstverständlich kann die Vorrichtung erwähntermaßen auch mehr als zwei Schlitten mit Werkzeugen und optischen Systemen umfassen, um gleichzeitig drei oder mehr Löcher zu bohren.

Die Justierung der Vorrichtung erfolgt vorzugsweise dadurch, daß eine normierte Vorlage mit Markierungen und Löchern auf der Unterlage (10) angeordnet werden, um das Werkzeug zu dem optischen System so einzustellen, daß die Werkzeuge deckungsgleich mit den Löchern und die Markierungen deckungsgleich unter sich und mit dem Fadenkreuz auf dem Bildschirm sind. Entsprechend der Vorlage werden dann in Druckplatten die Löcher in bezug auf die Markierungen eingebracht. Diesen sind beim Herstellen der Druckplatte selbstverständlich positionsgenau zu den Aufnahmen einer Schiene gemäß z.B. der US-PS 4,604,811 ausgerichtet, die ihrerseits auf einem Druckzylinder lösbar anordbar ist.

Anstelle einer dreidimensionalen Verschiebung des Werkzeugs (34) kann auch nur eine zweidimensionale erfolgen, nämlich dann, wenn die Druckplatte (11) auf die Werkzeuge (34) ausgerichtet wird. In diesem Fall müssen die Schlitten (16) und (18) nur entlang der Schienen (12) und (14) verschoben und die so gebildete Einheit beim Bohren abgesenkt werden. Die optischen Systeme müssen dann nicht zu dem Werkzeug drehbar ausgebildet sein. Vielmehr braucht diese Einheit nur entlang der Schienen verschoben und beim Bohren das Werkzeug abgegrenzt zu werden.

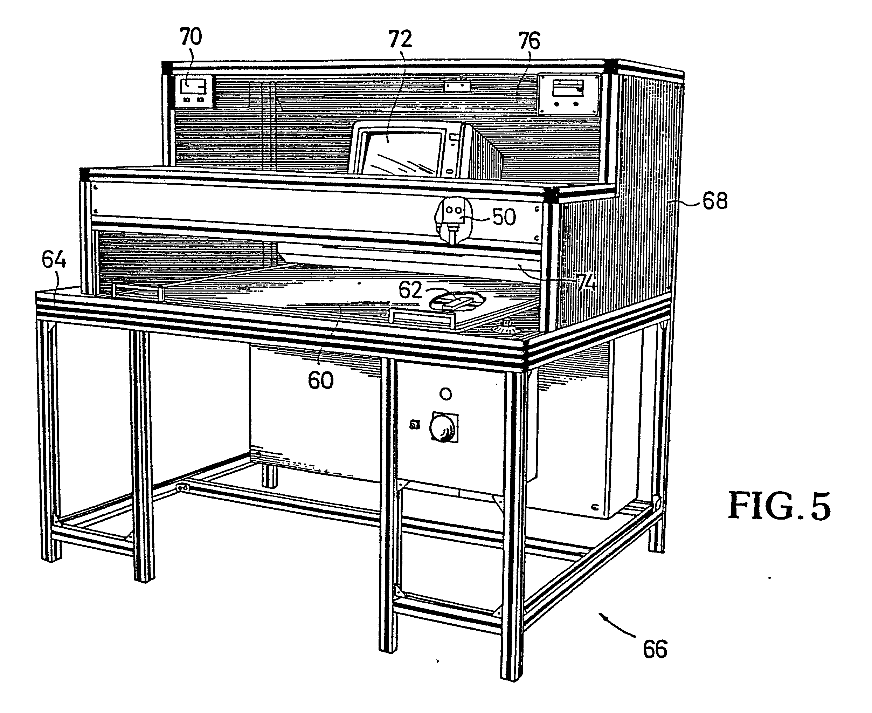

Der Fig. 4 ist eine besonders hervorzuhebende Ausführungsform einer Halterung bzw. eines Schlittens (50) zu entnehmen, von dem ein optisches System (38) der zuvor beschriebenen Art ausgeht. Parallel zur Längsachse des optischen Systems (38) verläuft die Längsachse (36) des Bohrers (34), der von einem einen nicht dargestellten Antrieb aufweisendem Gehäuse ausgeht, der mit dem Schlitten (50) verbunden ist. Beim Verschieben entlang der Wellen oder Schienen (12) und (14) bilden folglich Schlitten (50) und Gehäuse (56) eine Einheit. Wenn der Schlitten (50) in der Position angeordnet ist, in dem die zu beobachtende Markierung auf dem Monitor (44) positionsgenau abgebildet ist, wird das Gehäuse (56) mit dem Antrieb abgesenkt. Dieses Absenken bzw. Anheben wird durch den Pfeil (58) verdeutlicht.

Von dem Schlitten (50) geht des weiteren ein Niederhalter (52) aus, der pendelnd gelagert ist (Bezugszeichen (54)). Der Niederhalter (52) wird dann auf die zu bohrende Platte abgesenkt, wenn der Bohrvorgang durchgeführt werden soll, damit die Druckplatte nicht verrutschen kann. Um möglicherweise ein Verschieben der Druckplatte beim Absenken des Niederhalters (52) wieder auszugleichen, indem die Druckplatte zusammen mit der Auflage zum optischen System (38) verschoben wird, ist die pendelnde Halterung des Niederhalters (52) vorgesehen.

Das in der Zeichnung dargestellte Werkzeug ist ein Hohlbohrer (34), in den ein stabförmiges Element wie Stößel (34a) verschiebbar angeordnet ist. Wird der Hohlbohrer (34) angehoben, so erstreckt sich der Stößel (34a) soweit durch den Hohlbohrer (34) hindurch, das im Bohrer (34) zurückgehaltenes Druckplattenmaterial ausgestoßen wird.

In Fig. 5 ist eine bevorzugte Ausführungsform einer erfindungsgemäßen Vorrichtung zum Bohren von Registerlöchern in eine Photopolymerplatte dargestellt, um diese später auf einer Registerschiene paßgenau montieren zu können. Bekanntlich erhält ein Positivfilm bei der Montage eine Leiste mit Paßkreuzen oder einzelne entlang einer Geraden verlaufende Paßkreuze, wobei gewährleistet sein muß, daß diese parallel zum Motiv, also zur Druckzylinderachse verlaufen. Sodann wird ein Negativkontakt hergestellt. Dieser wird sodann auf eine Arbeitsfläche gelegt, die Paßkreuze auf optische Abbildungssysteme ausgerichtet und anschließend gebohrt.

Die Arbeitsfläche ist im Ausführungsbeispiel der Fig. 5 eine vorzugsweise aus Aluminium bestehende Tischplatte (60), die auf Magneten (62) verschiebbar gelagert ist. Die Tischplatte (60) ist zu einem Rahmen (64) eines Gehäuses (66) z. B. durch Federn selbstzentrierend angeordnet. In der Tischplatte sind nicht dargestellte Öffnungen vorhanden, die mit einer Vakuumeinrichtung verbunden sind, die ihrerseits vorzugsweise drei geschlossene Kreise umfaßt. Über die Öffnungen wird nach nachstehend beschriebener Ausrichtung der Druckplatte auf die optischen Abbildungssysteme eine Lagefixierung der Platte erreicht.

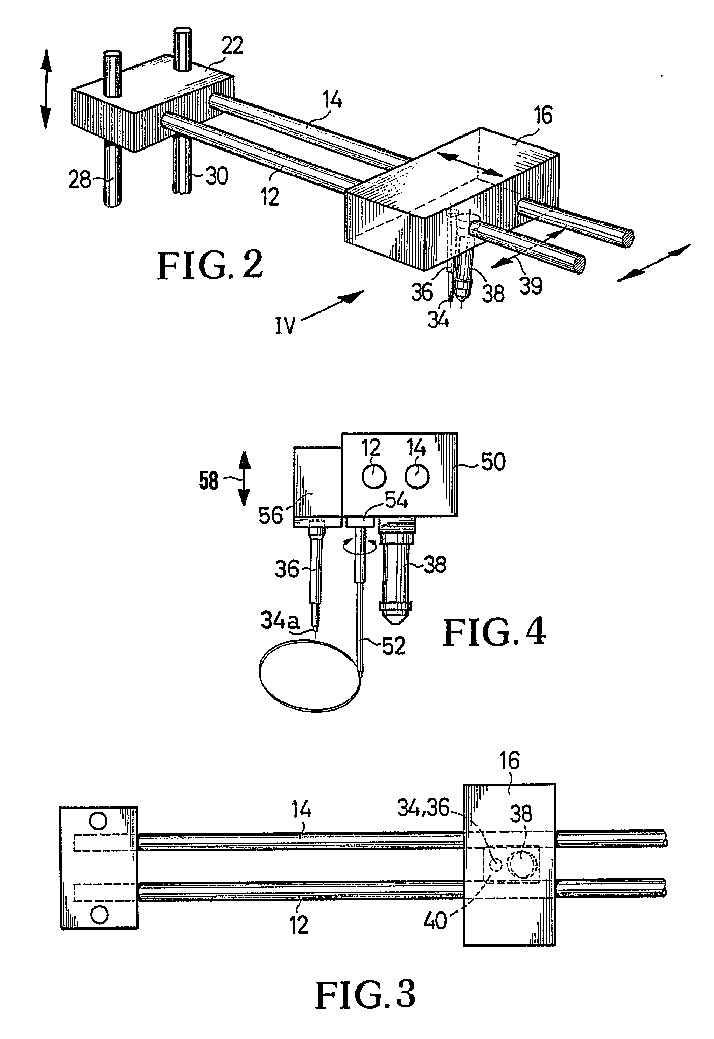

In einem oberen Gehäuseteil (68) sind parallel zur Platte (60) und parallel zur vorderen Kante des Rahmens (64) verlaufende Wellen angeordnet, die den Wellen (12) und (14) gemäß der Fig. 1 bis 4 entsprechen. Auf den Wellen ist ein Schlitten (50) entsprechend der Ausführungsform der Fig. 4 angeordnet. Von dem Schlitten (50) geht folglich ein optisches Abbildungssystem (38), ein Niederhalter (52) sowie ein Gehäuse (56) mit Bohrer (34) aus.

Auf den Wellen (12) und (14) sind bevorzugterweise zwei Schlitten (50) angeordnet. Das Verstellen der Schlitten (50) entlang der Wellen (12), (14) kann durch Handbetätigung oder zwangsangetrieben z.B. über Schrittmotoren erfolgen. Die Position der Schlitten (50) kann auf einem Display (70) abgelesen werden. Umgekehrt kann über Display die Stellung eingegeben werden, die von dem Schlitten angefahren werden soll.

Die optischen Abbildungssysteme bestehen vorzugsweise aus Videokameras, die in Verbindung mit einem Mischer gleichzeitig die Markierungen bzw. Paßkreuze auf dem Monitor (72) abbilden.

Da die Schienen und damit die optischen Abbildungssysteme von Verkleidungen abgedeckt sind, muß entweder in gebückter Haltung die Tischplatte (60) und die optischen Abbildungssysteme beobachtet werden, um eine Voreinstellung der optischen Systeme zu der Platte vorzunehmen, oder in aufrechter Position kann über ein Spiegelsystem (74), (76) das Verschieben der Schlitten (50) beobachtet werden. Die Spiegel (74) und (76) weisen dabei Neigungswinkel auf, die es ermöglichen, daß über den schräg gestellten Spiegel (76) die zu bohrende Druckplatte und die Stellung der optischen Abbildungssysteme (38) und damit der Bohrer (34) beobachtet werden kann.

Die Arbeitsweise mit der Vorrichtung gem. Fig. 5 ist nun die folgende.

Auf den Tisch (60) wird eine Druckplatte gelegt, die erwähntermaßen eine Paßkreuzleiste oder aber auch nur einzelne Paßkreuze aufweist. Die Schlitten (50) und damit die Werkzeuge (34) und die Platte werden so verschoben, daß die optischen Abbildungssysteme, also die Kameras (38) die auf der Platte angebrachten Paßkreuze aufnehmen können. Sobald die Paßkreuze fluchtend zu dem auf dem Monitor (72) vorhandenen Fadenkreuz abgebildet sind, wird das Vakuum eingeschaltet. Gleichzeitig wird die Platte durch den Niederhalter (52) fest auf den Tisch (60) gedrückt, so daß sich die Position auf der Tischplatte selbst nicht mehr verändern kann.

Durch das Anziehen des Vakuums und das Niederdrücken durch den Niederhalter kann ein Verschieben der Platte erfolgen. Dies bedeutet, daß die Paßkreuze nicht fluchtend zu dem Fadenkreuz auf dem Monitor abgebildet sind. Da die Platte nicht mehr zu dem Tisch (60) verschiebbar ist, wird dieser auf den Magneten (62) gelagerte verschoben. Sobald die Abbildungen der Paßkreuze auf dem Fadenkreuz liegen, werden die Magnete (62) aktiviert, so daß auch die Tischplatte (60) nicht mehr positionsveränderbar ist. Sodann wird der Bohrvorgang ausgelöst. Hierzu wird das Gehäuse (56) mit dem Antrieb abgesenkt. Hierzu wird ein Knopf betätigt. Wird dieser losgelassen, so fährt das Werkzeug in die ursprüngliche Position zurück, also die der Fig. 4 zu entnehmende. Gleichzeitig wird das Vakuum automatisch aufgehoben. Auch werden die Magnete abgeschaltet. Der Niederhalter wird wegbewegt, so daß die gebohrte Platte entnommen werden kann. Durch das Abschalten des Magneten erfolgt gleichzeitig ein automatisches Zentrieren der Tischplatte (60). Beim Zurückfahren des Werkzeugs (34) wird gleichzeitig das Material ausgestoßen, das im Hohlbohrer zurückgeblieben ist. Hierzu verläuft in dem Hohlbohrer der Stößel (34a).

**Ansprüche**

1. Verfahren zum Einbringen von Löchern in eine Druckplatte insbesondere aus photopolymerem Material oder Gummi, wobei Werkzeuge wie Bohrer auf auf der Druckplatte vorhandene Markierungen wie Paßkreuze ausgerichtet werden, **dadurch gekennzeichnet,** daß jeder Bohrer einem optischen Abbildungssystem zugeordnet wird, daß die von den Abbildungssystemen erfaßten Markierungen auf eine einzige Beobachtungsfläche abgebildet werden und daß die Löcher dann eingebracht werden, wenn die Markierungen deckungsgleich auf der Beobachtungsfläche abgebildet sind.

2. Verfahren nach Anspruch 1, **dadurch gekennzeichnet,** daß die Bohrer in bezug auf die zugeordneten Markierungen positionsgenau dadurch ausgerichtet werden, daß die abgebildeten Markierungen in Form von Kreuzen im Zentrum eines auf der Beobachtungsfläche vorhandenen Fadenkreuzes abgebildet werden und die Achsen der Kreuze mit denen des Fadenkreuzes zusammenfallen.

3. Verfahren nach Anspruch 1, **dadurch gekennzeichnet,** daß eine der Anzahl der Werkzeuge entsprechende Anzahl von Löchern gleichzeitig gebohrt werden.

4. Verfahren nach Anspruch 1, **dadurch gekennzeichnet,** daß die von den Abbildungssystemen gewonnenen Informationen digitalisiert, bewertet und einer Steuereinheit zum Positionieren der Werkzeuge und/oder zum Einbringen von Löchern zugeführt werden.

5. Verfahren nach Anspruch 1, **gekennzeichnet durch** die Verfahrensschritte,

   a) Auflegen einer Photopolymerplatte auf eine ebene Fläche wie Tisch

   b) Verschieben des optischen Systems und/oder der Photopolymerplatte derart, daß die Markierungen auf einer optischen Beobachtungsfläche und vorzugsweise auf eine Markierung auf dieser abgebildet werden,

   c) Fixieren der Photopolymerplatte auf der Fläche durch

   Unterdruck und/oder Niederhalter,

   d) gegebenenfalls Verschieben der Fläche zum erneuten Ausrichten der Abbildungen der Markierungen auf der optischen Beobachtungsfläche und

   e) Bohren der Photopolymerplatte.

6. Vorrichtung (66) zum Einbringen von Löchern in eine Druckplatte (11) insbesondere aus photopolymerem Material, wobei die Werkzeuge (34) wie Hohlbohrer nach Ausrichten auf einzubringenden Löchern (17, 19) zugeordnete Markierungen (13, 15) betätigbar sind, **dadurch gekennzeichnet,** daß jedem Werkzeug (34) ein auf die Markierung (13, 15) auszurichtendes optisches Abbildungssystem (38) zugeordnet ist und daß zur Abbildung der von den Abbildungssystemen erfaßten Bilder eine einzige Beobachtungsfläche (44, 72) vorgesehen ist.

7. Vorrichtung nach Anspruch 5, **dadurch gekennzeichnet,** daß jedes Werkzeug (34) und das zugeordnete Abbildungssystem (38) an einem Schlitten (16, 18, 50) befestigt ist, der relativ zu der Druckplatte (11) bewegbar ist.

8. Vorrichtung nach Anspruch 7, **dadurch gekennzeichnet,** daß sämtliche Schlitten (16, 18, 50) entlang derselben Führungs- bzw. Halteelemente (12, 14) verschiebbar sind, die ihrerseits in bezug auf die auf einer Bearbeitungsfläche (10, 60) wie Tisch aufliegenden Druckplatte (11) parallel und senkrecht relativ zu dieser bewegbar sind.

9. Vorrichtung nach Anspruch 6, **dadurch gekennzeichnet,** daß das optische System (38) ein Endoskop oder eine Videokamera ist.

10. Vorrichtung nach Anspruch 5,

**dadurch gekennzeichnet,**

daß das optische System (38) und das Werkzeug (34) mit einem an einer von dem Schlitten (16, 18) ausgehenden Halterung (40) befestigt sind, die um eine mit der Werkzeuglängsachse (36) zusammenfallenden Achse drehbar ist wobei die Position des Schlittens und oder der Halterung über vorzugsweise Schrittmotoren einstellbar ist.

11. Vorrichtung nach Anspruch 6,
**dadurch gekennzeichnet,**

daß die Halterung (40) relativ zu dem Schlitten (16, 18) und vorzugsweise senkrecht zu der Längsachse der Führungs- bzw. Halteelemente (12, 14) verschiebbar ist.

12. Vorrichtung nach Anspruch 6,
**dadurch gekennzeichnet,**

daß das Werkzeug (34) ein Hohlbohrer ist, der beim Abheben von der Druckplatte (11) derart von einem Stößel (34a) durchsetzt ist, daß in dem Werkzeug zurückgehaltenes Druckplattenmaterial ausstoßbar ist.

13. Vorrichtung nach Anspruch 6,
**dadurch gekennzeichnet,**

daß von dem das optische System (38) haltenden Schlitten (50) ein pendelnd gelagerter Niederhalter (52) ausgeht.

7

# FIG.1

FIG.2

IV

FIG.4

FIG.3

FIG.5

EP 0 357 961 A2